# EUROPEAN PATENT APPLICATION

(11) **EP 2 199 815 A1**
(43) Date of publication of application: **23.06.2010**
(21) Application number: 08172518.6
(22) Date of filing: 22.12.2008
(51) Int. Cl.: G01R 33/28

(54) **MR imaging with CEST contrast enhancement**

(71) Applicant: Koninklijke Philips Electronics N.V., 5621 BA Eindhoven (NL); Philips Intellectual Property & Standards GmbH, 20099 Hamburg (DE)
(72) Inventor: The designation of the inventor has not yet been filed
(74) Representative: Damen, Daniel Martijn

(57) **Abstract**

The invention relates to a method of MR imaging of at least a portion of a body of a patient placed in an examination volume of an MR device. The object of the invention is to improve CEST contrast enhanced imaging. The method of the invention comprises the following steps:
a) saturation of nuclear magnetization of exchangeable protons of a CEST contrast agent administered to the patient by subjecting the portion of the body to at least one frequency-selective saturation RF pulse matched to the MR frequency of exchangeable protons of the CEST contrast agent, wherein the saturation period, i.e. the duration of the frequency-selective saturation RF pulse, is shorter than the time required for saturation to build up a full CEST contrast enhancement effect when starting from zero saturation;
b) generating at least one MR signal of water protons of the body by subjecting the portion of the body to an MR imaging sequence comprising at least one RF pulse and switched magnetic field gradients;
c) acquiring and sampling the at least one MR signal from the body;
d) repeating steps a) to c) a number of times under variation of parameters of the MR imaging sequence;
e) reconstructing a proton-density weighted, CEST contrast-enhanced MR image from the acquired and sampled MR signals.

## Description

### BACKGROUND OF THE INVENTION

The invention relates to the field of magnetic resonance (MR) imaging. It concerns a method of MR imaging of at least a portion of a body of a patient placed in an examination volume of an MR device. The invention also relates to an MR device and to a computer program to be run on an MR device.

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field whose direction at the same time defines an axis (normally the z axis) of the co-ordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the magnetic field extends perpendicular to the z axis, so that the magnetization performs a precessional motion about the z axis. The precessional motion describes a surface of a cone whose angle of aperture is referred to as the flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is build up again with a first time constant T₁ (spin-lattice or longitudinal relaxation time) and the magnetization in the direction perpendicular to the z direction relaxes with a second time constant T₂ (spin-spin or transverse relaxation time). The variation of the magnetization can be detected by means of a coil which is customarily oriented in such a manner that the variation of the magnetization is measured in the direction perpendicular to the z axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the detection coil.

In order to realize spatial resolution in the body, linear magnetic-field gradients extending along the three main axes are superposed on the uniform magnetic field, leading to a linear spatial dependency of the spin resonance frequency. The signal picked up in the detection coil then contains components of different frequencies which can be associated with different locations in the body after Fourier transformation from the time domain to the frequency domain.

Sometimes the difference in MR signal intensity, i.e. contrast, between different tissues is not sufficient to obtain a satisfactory clinical information and MR contrast agents are then used. The importance of the use of contrast agents in MR imaging is growing. Currently used contrast agents comprise (typically) paramagnetic materials, which influence the relaxation process of the nearby water ¹H nuclei (protons) and so lead to a local change of the image contrast. Such contrast agents are, for example, Gd-DTPA or Gd-DOTA, which are administered to enhance the contrast between healthy and diseased tissue. These paramagnetic contrast agents reduce the longitudinal or transverse relaxation times of the protons. This can be used, for example, to generate a positive (bright) contrast in a T₁-weighted MR image or a negative (dark) contrast in T₂-weighted MR images.

An alternative approach to generate contrast enhancement has been described by Balaban et al. (see US 6,962,769 B1). This known method is based on 'Chemical Exchange Saturation Transfer' (CEST). With this CEST technique, the image contrast is obtained by altering the intensity of the water proton signal. This is achieved by selectively saturating the MR signal of the exchangeable protons of the CEST contrast agent. A frequency-selective saturation RF pulse that is matched to the MR frequency of the exchangeable protons of the CEST contrast agent is used for this purpose. The saturation of the MR signal of the exchangeable protons is subsequently transferred to the MR signal of nearby water protons within the body of the examined patient by (chemical or physical) exchange with the water protons, thereby decreasing the water proton MR signal. The selective saturation at the MR frequency of the exchangeable protons of the contrast agent thus gives rise to a negative contrast enhancement in a proton-density weighted MR image. As the result of the finite spectral width of both the bulk water MR signal and the selective saturation RF pulse, unintended direct saturation of the protons of the bulk water MR signal will always to some extend cause an additional attenuation. In case the spectrum of the bulk water MR signal is symmetric, the amount of direct saturation can be determined by means of a reference measurement in which the frequency of the selective saturation RF pulse is set at the opposite side of the spectral position of the bulk water MR signal.

CEST contrast agents have several important advantages over T₁- and T₂-based MR contrast agents. CEST contrast agents allow for multiplexing by using a single compound or a mixture of compounds bearing exchangeable protons that can be addressed separately in one single multi-frequency CEST MR examination. This is of particular interest for molecular imaging, where multiple biomarkers may be associated with several unique CEST frequencies. Moreover, the MR contrast can be turned on and off at will by means of the selective saturation RF pulse. Adjustable contrast enhancement is highly advantageous in many applications, for example when the selective uptake of the contrast agent in the diseased tissue in examined body is slow. When using existing T₁- and T₂-contrast agents in such cases, two separate MR investigations are required: one for the acquisition of the contrast-enhanced image and the second one - typically on the previous day - to obtain a reference image for a background correction. Using CEST, the reference image can be obtained immediately before or after the contrast-enhanced image. As a consequence, a single MR examination session suffices. The latter advantage can be exploited further using a technique called 'modulated CEST' (see WO 2006/114765 A2). In modulated CEST examinations a series of MR images is recorded continuously during a longer period of time while the CEST contrast enhancement is modulated according to a given protocol, for example by modulating the power or the frequency of the selective saturation RF pulse. This causes a modulation of the CEST-induced contrast in the obtained images, which is correlated with the used modulation protocol. The modulated CEST approach has the potential to further improve the sensitivity of CEST MR imaging.

A drawback of all known CEST MR imaging techniques is that the selective saturation prior to the actual acquisition of image data takes a comparably long time. The build-up of the saturation of the protons of the CEST contrast agent is a relatively slow process (the characteristic timescale is on the order of one second). Consequently, the saturation period used in known CEST measurements is typically 2-15 seconds. Then, immediately following the saturation period, a (slice-selective) excitation RF pulse is usually applied for generation of the bulk water MR signal and one or more MR signals are recorded, for example as gradient echoes or spin echoes. The acquisition of the MR signals used for imaging takes typically only several milliseconds. Finally, in order to let the saturation decay to zero and to prevent undesired T₁-weighted contrast enhancement in the MR image, a relaxation delay of at least two seconds is usually included before starting the next cycle of the MR signal acquisition. As a result, the total duration of a single measurement is significantly more than two seconds. In most practical cases (in particular at high magnetic field strengths and relatively short T₂ relaxation times), multiple measurements will be necessary to obtain sufficient coverage of k-space and the total time needed to obtain a CEST-weighted MR image will increase proportionally.

For several reasons it is desirable to measure CEST-enhanced MR images at a much higher rate than the known approaches permit. This applies, for example, to image-guided drug delivery, since it would enable real-time monitoring of drug-release. Additionally, fast CEST imaging would enable the study of the dynamics of the CEST contrast agent inflow and wash-out in the tissue of the examined patient immediately after the administration of the contrast agent. Such dynamics are relevant indicators of diseased tissue and of the effect of therapeutic treatment. Faster measurement would also be advantageous for modulated CEST imaging at high temporal resolution. Fast modulated CEST imaging would help to reduce image artifacts due to patient motion since the rate at which CEST-weighted images are acquired can be much higher than, for example, the respiratory frequency of the examined patients. Consequently, image artifacts due to respiratory motion could be suppressed more efficiently during MR image reconstruction. A further issue in CEST imaging is associated with the lengthy saturation period prior to the actual MR signal acquisition. The necessary saturation step inhibits the common approach of interleaved acquisition of multiple image slices. Therefore, in multi-slice CEST imaging the imaging time increases proportionally to the number of slices. The imaging time can easily exceed ten minutes, which has an adverse effect on patient comfort.

### SUMMARY OF THE INVENTION

From the foregoing it is readily appreciated that there is a need for an improved CEST imaging technique. It is consequently an object of the invention to enable fast MR imaging with CEST contrast enhancement.

In accordance with the invention a method of MR imaging of at least a portion of a body of a patient placed in an examination volume of a MR device is disclosed. The method of the invention comprises the following steps:
a) saturation of nuclear magnetization of exchangeable protons of a CEST contrast agent administered to the patient by subjecting the portion of the body to a frequency-selective saturation RF pulse (or a train of frequency-selective saturation RF pulses) matched to the MR frequency of exchangeable protons of the CEST contrast agent, wherein the saturation period, i.e. the duration of the frequency-selective saturation RF pulse (or saturation RF pulse train), is shorter than the time required for saturation to build up a full CEST contrast enhancement effect when starting from zero saturation of the magnetization of the exchangeable protons of the CEST contrast agent and/or the bulk water protons;
b) generating at least one MR signal of water protons of the body by subjecting the portion of the body to an MR imaging sequence comprising at least one RF pulse and switched magnetic field gradients;
c) acquiring and sampling the at least one MR signal from the body;
d) repeating steps a) to c) a number of times under variation of parameters (such as, for example, phase encoding, slice position, echo times etc.) of the MR imaging sequence;
e) reconstructing a (proton-density weighted, CEST contrast- enhanced) MR image from the acquired and sampled MR signals.

The invention proposes to saturate the exchangeable protons of the CEST contrast agent essentially continuously, while the acquisition of the MR signals used for reconstruction of a single MR image or a (dynamic) series of consecutive MR images is performed during short intervals, in which the RF irradiation used for saturation is briefly interrupted. If the interruption interval required for MR signal generation and acquisition (steps b) and c)) is sufficiently short, the continuity of the selective saturation is only minimally disturbed. After several cycles of steps a) to c) needed to build up saturation, a virtually complete saturation (i.e. a 'steady-state' CEST effect) remains in each MR signal acquisition step from the preceding acquisition cycle. An essential feature of the invention is that the duration of the saturation period is (much) shorter (at least by a factor of 5 or 10) than the time required to build up complete saturation of the nuclear magnetization of the exchangeable protons of the CEST contrast agent when starting from zero saturation. Consequently, the time needed for saturation prior to each MR signal acquisition step is very short according to the invention as compared to conventional CEST imaging approaches. The surprising effect of the invention is that an almost full-sized CEST contrast enhancement effect can be obtained even though the duration of the saturation period is so much shorter than in conventional CEST approaches. This is due to the repetitive re-use of pre-existing saturation generated during previous cycles of steps a) to c).

Especially the combination of the fast CEST MR imaging method of the present invention with existing techniques for rapid MR imaging (like FLASH, EPI and SENSE) constitutes a powerful tool for contrast-enhanced diagnostic MR imaging.

According to a preferred embodiment of the invention, the duration of the MR imaging sequence in step b) is selected such that the exchangeable protons of the CEST contrast agent remain saturated until irradiation of the subsequent saturation RF pulse in step a). As explained above, if the duration of the saturation and signal acquisition steps are selected properly, saturation remains after each MR signal acquisition step such that the following saturation does not have to start form zero as in the conventional CEST approaches. Preferably, the duration of the MR imaging sequence in step b) is shorter than the duration of the saturation RF pulse in step a). An important aspect of the invention is that the exchangeable protons of the CEST contrast agent are essentially continuously saturated, wherein the generation and acquisition of MR signals for image generation (steps b) and c)) take place during sufficiently short interruptions of the irradiation of the frequency-selective saturation RF pulse. In a preferred embodiment of the method of the invention, the duration of the saturation RF pulse is 1-1000 milliseconds, preferably 2-200 milliseconds, while the duration of the MR imaging sequence is 1-100 milliseconds, preferably 1-50 milliseconds. In this way, a continuous series of CEST-enhanced MR images can be acquired (for example for dynamic or modulated CEST imaging) with a time resolution on the order of only 100 milliseconds or less.

It is advantageous to use RF pulses with small flip angles (1-10°) for the generation of MR signals in step b), in order to prevent direct saturation of the bulk water MR signal while repeating steps a) to c). However, a small flip angle is not essential for a successful application of the method of the invention. The CEST imaging approach of the invention may also be combined with 'true FISP' or 'balanced FFE' MR imaging methods. Such gradient-balanced MR imaging techniques effectively help to avoid unwanted direct saturation of the MR signal of water protons of the examined body.

As mentioned before, it turns out that after a certain number of repetitions of steps a) to c) of the method of the invention, a steady state of saturation of the exchangeable protons of the CEST contrast agent is achieved. In this steady state a complete or nearly complete saturation can be made use of for CEST contrast enhancement. It is an important aspect of the invention that the CEST technique may be applied in this steady state of saturation. A significant increase of imaging speed can be obtained because there is no need to wait for a re-build of the saturation of the exchangeable protons of the CEST contrast agent prior to each MR signal acquisition step. However, it is also possible in accordance with the invention to acquire MR signals during the saturation build-up period, i.e. before the steady state is achieved. Preferably only the peripheral portions of k-space are sampled by means of the MR imaging sequence before the full saturation is obtained, i.e. during the saturation build-up period. In order to obtain optimum contrast in the finally reconstructed MR image, the central k-space regions are sampled after the saturation plateau has been reached. This approach of acquiring the outer k-lines right from the beginning of saturation enables an even faster way of producing CEST-enhanced MR images.

According to a further preferred embodiment of the invention, the frequency-selective saturation RF pulse irradiated in step a) is a non-rectangular shaped pulse. At shorter saturation pulse durations (such as, e.g., below 100 ms) certain shaped RF pulses have improved frequency-selectivity as compared to rectangular pulses and consequently better prevent unwanted direct saturation of the bulk water signal that might occur while continuously repeating steps a) to c). Conventional shaped RF pulses (like Gaussian-, sinc.-, or so-called E-BURP-shaped pulses might be used instead of, for example, a 100 millisecond rectangular saturation RF pulse. Also frequency-swept selective saturation RF pulses, like, for example CHIRP pulses, might be used. Such pulses strongly reduce unwanted coherences of the nuclear magnetization because of their quadratic phase behavior. Additionally, frequency-swept saturation RF pulses potentially enable a narrow excitation profile with an RF pulse that has a relatively short duration and a relatively constant RF amplitude. As a consequence, such pulses potentially enable selective saturation with minimal RF power deposition in the patient.

The method of the invention described thus far can be carried out by means of an MR device including at least one main magnet coil for generating a uniform, steady magnetic field within an examination volume, a number of gradient coils for generation of switched magnetic field gradients in different spatial directions within the examination volume, at least one RF coil for generating RF pulses within the examination volume and for receiving MR signals from a body of a patient positioned in the examination volume, a control unit for controlling the temporal succession of RF pulses and switched magnetic field gradients, a reconstruction unit, and a visualization unit.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

The enclosed drawings disclose preferred embodiments of the present invention. It should be understood, however, that the drawings are designed for the purpose of illustration only and not as a definition of the limits of the invention.

### BRIEF DESCRIPTION OF THE DRAWINGS

In the drawings
Figure 1 shows an MR device for carrying out the method of the invention;
Figure 2 shows a diagram illustrating the sequence of RF pulses and switched magnetic field gradients for CEST imaging according to the invention;
Figure 3 shows an alternative embodiment of the method of the invention using an EPI imaging sequence;
Figure 4 shows a further embodiment using a train of shaped RF pulses for saturation;
Figure 5 shows still a further embodiment using a gradient-balanced MR imaging sequence;
Figure 6 shows a diagram in which the normalized MR image intensity is depicted as a function of time in order to illustrate the saturation build-up in accordance with the invention.

### DETAILED EMBODIMENTS

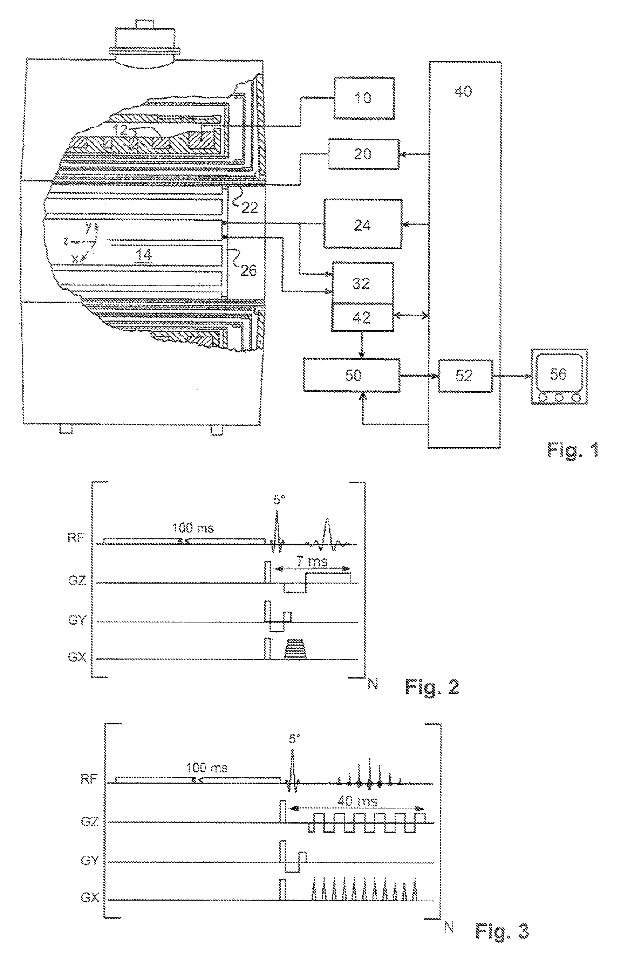

With reference to Figure 1, a main magnet field control 10 controls superconducting or resistive main magnets 12 such that a substantially uniform, temporally constant main magnetic field is created along a z axis through an examination volume 14.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, gradient pulse amplifiers 20 apply current pulses to selected ones of pairs of whole-body gradient coils 22 to create magnetic field gradients along x, y and z-axes of the examination volume 14. A digital RF frequency transmitter 24 transmits RF pulses or pulse packets to a hole-body RF coil 26 to transmit RF pulses into the examination volume 14. A typical MR imaging sequence is composed of a packet of pulse segments of short duration which taken together with each other and any applied gradients achieve a selected manipulation of nuclear magnetic resonance. The RF pulses are used to saturate, excite resonance, invert magnetization, refocus resonance, or manipulate resonance and select a portion of a body (not shown) of an examined patient positioned in the examination volume 14. For whole-body applications, the MR signals are commonly picked up by the whole-body RF coil 26.

For generation of MR images of limited regions of the body of the patient, local coils (not shown) are commonly placed contiguous to the selected region. For example, a receive-only local RF coil can be used to receive MR signals introduced by body-coil RF transmissions.

The resultant MR signals are picked up by the whole-body RF coil 26 or other specialized RF coils and demodulated by a receiver 32 preferably including a preamplifier (not shown).

A host computer 40 controls the gradient pulse amplifiers 20 and the transmitter 24 to generate any of a plurality of MR imaging sequences, such as echo planar imaging (EPI), echo volume imaging, gradient and spin echo imaging, fast spin echo imaging, and the like. For the selected sequence, the receiver 32 receives a single or a plurality of MR data lines in rapid succession following each RF excitation pulse. A data acquisition system 42 performs analog-to-digital conversion of the received signals and converts each MR data line to a digital format suitable for further processing. In modern MR devices the data acquisition system 42 is a separate computer which is specialized in acquisition of raw image data.

Ultimately, the digital raw image data is reconstructed into an image representation by a reconstruction processor 50 which applies a Fourier transform or other appropriate reconstruction algorithm. The MR image may represent a planar slice through the patient, an array of parallel planar slices, a three-dimensional volume, or the like. The image is then stored in an image memory 52 of the host computer 40 where it may be accessed for converting slices, projections, or other portions of the image representation into appropriate format for visualization, for example via a video monitor 56 which provides a manreadable display of the resultant MR image.

With reference to Figure 2, a first embodiment of the CEST imaging approach of the invention is explained. Each generation of MR signals for data read-out is preceded by a short (100 milliseconds) frequency-selective saturation RF pulse (magnetic field amplitude in the range of 1-10 µT) for saturating the nuclear magnetization of the exchangeable protons of the used CEST contrast agent. The short saturation period is not sufficient to build up a (nearly) complete CEST effect from zero. However, a series ofN (N being any integer larger than or equal to 2) of such periods, provided that the intervals during which the saturation is interrupted for MR signal acquisition are sufficiently short, will act similar to a long frequency-selective saturation RF pulse as used in conventional CEST techniques. The generation of MR signals and the acquisition and sampling of the MR signals are performed during the short intervals between the repeated irradiation of the saturation RF pulse. In the embodiment shown in Figure 2, crusher gradients GZ, GY, and GX are applied after the saturation RF pulse. The crusher gradients are followed by a slice-selective RF pulse for exciting nuclear magnetization of the water protons of the body. A small flip angle (5°) is used in order prevent direct saturation of the water protons. Frequency-encoding and phase-encoding are performed by switched magnetic field gradients GZ and GX respectively. The sequence shown in Figure 2 is repeated N times under variation of the phase-encoding until a complete set of MR image data is acquired.

With reference to Figure 3, the MR imaging sequence used in Figure 2 is replaced by an EPI sequence in which several k-space lines are acquired after each excitation RF pulse.

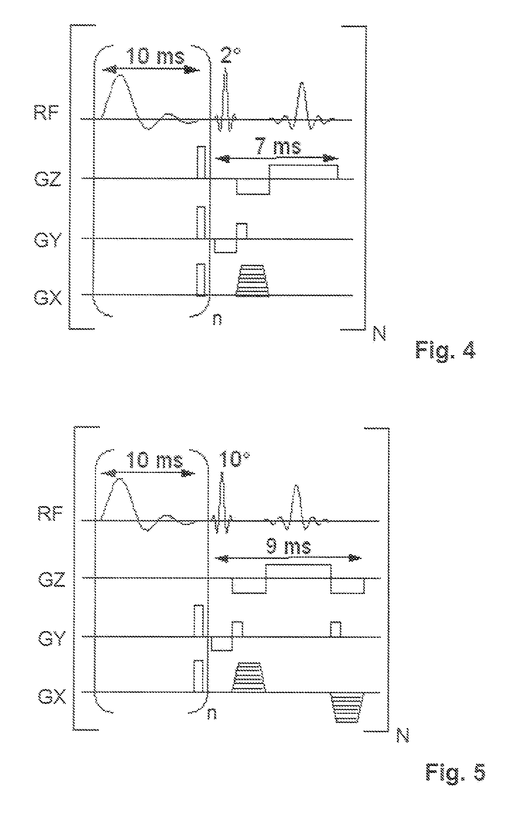

With reference to Figure 4, a further embodiment of the technique of the invention uses a (train of) n (n being any integer larger than or equal to 1) shaped RF pulses for frequency-selective saturation of the exchangeable protons of the CEST contrast agent. Undesired coherences of nuclear magnetization can be effectively avoided by using the shaped RF pulses instead of (nearly) continuous-wave RF irradiation for saturation as shown in Figures 2 and 3. Since the repetition time is further decreased in this embodiment, the flip angle of the excitation RF pulse is decreased as well to 2°, in order to prevent direct saturation of the bulk water signal.

With reference to Figure 5, the embodiment shown in Figure 4 is extended to a fully gradient-balanced version, again in order to prevent direct saturation of the bulk water signal. Now relatively large flip angles (10°) of the excitation RF pulse can be used, which leads to an improved contrast-to-noise ratio.

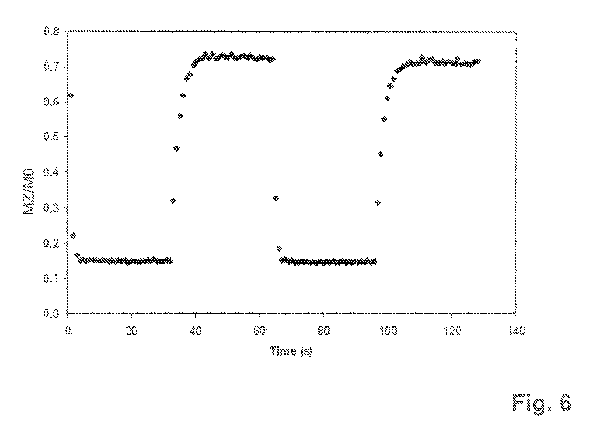

With reference to Figure 6, relative integrals MZ/M0 of a series of CEST MR images acquired in accordance with the invention are depicted as a function of time. In 72 seconds, a series of 128 CEST-enhanced MR images were acquired. During the initial set of 32 images, a rectangular saturation RF pulse of 100 milliseconds duration was used, wherein the frequency of the saturation RF pulse was matched to the MR frequency of the exchangeable protons of the CEST contrast agent. After each set of 32 images, the frequency of the saturation RF pulses was set in the spectrum exactly at the opposite side of the bulk water MR signal (in other words, the sign of the frequency offset of the saturation RF pulse relative to the water line was inverted). After completion of the data acquisition (four sets of 32 MR images) all MR images were reconstructed in magnitude mode by using Fourier transformation. The integral MZ of each MR image was computed for each image. Normalization was performed by dividing each integral value MZ by the integral M0 of a corresponding MR image acquired in which the saturation frequency offset was set at an 'infinitely' large distance (100 kHz) off the bulk water spectral line. The obtained normalized values MZ/M0 are plotted in Figure 6 as a function of time. As can be seen in the diagram, the MR image intensity decreases within the series of the initial MR images until a plateau value is reached after approximately 4 MR images. This decrease is due to the initial saturation build-up of the exchangeable protons of the CEST contrast agent. The plateau illustrates the steady state of saturation which is made use of by the invention. After 32 images (corresponding to 18 seconds), when the frequency of the saturation RF pulse is changed, the exchangeable protons are no longer saturated and the MR image intensity slowly returns to the equilibrium value. Then, after another 18 seconds, the frequency of the saturation RF pulse is changed back again to the frequency of the exchangeable protons and the MR image intensity decreases and reaches the same plateau value previously observed. Finally, after another 18 seconds, the frequency of the saturation RF pulse is changed again, and the MR image intensity increases until it returns to the equilibrium value. The relative CEST effect, calculated as the intensity difference between the upper and the lower plateau values shown in figure 6, is approximately 80 %. This magnitude of the CEST effect is in good agreement with values reported in the literature using the same CEST contrast agent Eu(III)DOTAMGly (see Terreno et al., Investigative Radiology, 39:235-243). This demonstrates that the CEST effect in the steady state approach of the invention is essentially the same as in the conventional CEST imaging approach. However, the advantage of the method of the invention is that the speed of image acquisition is significantly increased.

## Claims

**1.** Method of MR imaging of at least a portion of a body of a patient placed in an examination volume of an MR device, the method comprising the steps of:
a) saturating nuclear magnetization of exchangeable protons of a CEST contrast agent administered to the patient by subjecting the portion of the body to at least one frequency-selective saturation RF pulse matched to the MR frequency of exchangeable protons of the CEST contrast agent, wherein the saturation period, i.e. the duration of the frequency-selective saturation RF pulse or the duration of a train of frequency-selective saturation RF pulses, is shorter than the time required to build up a full CEST effect starting from zero saturation;
b) generating at least one MR signal of water protons of the body by subjecting the portion of the body to an MR imaging sequence comprising at least one RF pulse and switched magnetic field gradients;
c) acquiring and sampling the at least one MR signal from the body;
d) repeating steps a) to c) a number of times under variation of parameters of the MR imaging sequence;
e) reconstructing an MR image from the acquired and sampled MR signals.

**2.** Method of MR imaging of claim 1, wherein the duration of the MR imaging sequence in step b) is selected such that the CEST effect built up during previous cycles of step a) to c) remains at least partially intact until irradiation of the subsequent saturation RF pulse in step a).

**3.** Method of claim 2, wherein the duration of the MR imaging sequence in step b) is shorter than the duration of the saturation RF pulse in step a).

**4.** Method of any one of claims 1-3, wherein the duration of the saturation RF pulse is 1-1000 milliseconds, preferably 2-200 milliseconds.

**5.** Method of any one of claims 1-3, wherein the duration of the MR imaging sequence is 1-100 milliseconds, preferably 1-50 milliseconds.

**6.** Method of any one of claims 1-5, wherein the MR imaging sequence is a gradient-balanced sequence.

**7.** Method of any one of claims 1-6, wherein the MR imaging sequence is a gradient echo sequence, preferably an EPI sequence.

**8.** Method of any one of claims 1-7, wherein the number of repetitions of steps a) to c) is selected such that a steady state of the saturation of the nuclear magnetization of the exchangeable protons of the CEST contrast agent is achieved.

**9.** Method of claim 8, wherein only peripheral portions of k-space are sampled by means of the MR imaging sequence during a saturation build-up period, i.e. before the steady state is achieved.

**10.** Method of any one of claims 1-9, wherein the saturation RF pulse is a non-rectangular shaped pulse.

**11.** Method of any one of claims 1-10, wherein the saturation RF pulse is a frequency-swept pulse.

**12.** MR device for carrying out the method claimed in claims 1-11, which MR device includes at least one main magnet coil (12) for generating a uniform, steady magnetic field within an examination volume, a number of gradient coils (22) for generating switched magnetic field gradients in different spatial directions within the examination volume, at least one RF coil (26) for generating RF pulses within the examination volume and for receiving MR signals from a body of a patient positioned in the examination volume, a control unit (40) for controlling the temporal succession of RF pulses and switched magnetic field gradients, a reconstruction unit (50) and a visualization unit (56) wherein the MR device is arranged to perform the following steps:
a) saturating nuclear magnetization of exchangeable protons of a CEST contrast agent administered to the patient by radiating, via the RF coil (26), at least one frequency-selective saturation RF pulse towards the body of the patient, wherein the saturation RF pulse is matched to the MR frequency of the exchangeable protons of the CEST contrast agent, and wherein the saturation period, i.e. the duration of the frequency-selective saturation RF pulse or the duration of a train of frequency-selective saturation RF pulses, is shorter than the time required to build up a full CEST effect starting from zero saturation;
b) generating at least one MR signal of water protons of the body by subjecting the body to a MR imaging sequence comprising at least one RF pulse and switched magnetic field gradients;
c) acquiring the at least one MR signal from the body via the RF coil (26);
d) repeating steps a) to c) a number of times under variation of parameters of the MR imaging sequence;
e) reconstructing an MR image, by means of the reconstruction unit (50), from the acquired MR signals, and displaying the reconstructed MR image via the visualization unit (56).

**12.** A computer program to be run on an MR device, which computer program comprises instructions for:
a) generating at least one frequency-selective saturation RF pulse matched to the MR frequency of exchangeable protons of a CEST contrast agent, wherein the saturation period, i.e. the duration of the frequency-selective saturation RF pulse or the duration of a train of frequency-selective saturation RF pulses, is shorter than the time required to build up a full CEST effect when starting from zero saturation;
b) generating an MR imaging sequence comprising at least one RF pulse and switched magnetic field gradients;
c) record at least one MR signal;
d) repeating steps a) to c) a number of times under variation of parameters of the MR imaging sequence;
e) reconstructing an MR image from the recorded MR signals.
